# EUROPEAN PATENT APPLICATION

(11) **EP 4 645 100 A2**
(43) Date of publication of application: **05.11.2025**
(21) Application number: 25173387.9
(22) Date of filing: 29.04.2025
(51) Int. Cl.: G06F 12/02

(54) **WEAR LEVELING START-GAP ALGORITHM USING MULTIPLE GAP LOCATIONS**

(30) Priority: 02.05.2024 US 202463641667 P; 29.07.2024 US 202418787724
(71) Applicant: Micron Technology, Inc, Boise ID 83707 (US)
(72) Inventor: LAURENT, Christophe, AGRATE BRIANZA (MONZA E BRIANZA) (IT); CANCLINI, Fabio, VILLASANTA (MONZA E BRIANZA) (IT)
(74) Representative: Pio, Federico

(57) **Abstract**

Systems, methods, and apparatus for memory management operations in a memory device. In one approach, wear leveling for the memory device is performed using a start-gap algorithm. The wear leveling is implemented using multiple gap locations in a single pool. In response to a memory management command, one or more gap locations and corresponding user data are moved. After moving the user data, one or more pointers to the gap locations are updated. A start location pointer for the pool is updated each time the gap locations complete a cycle of movement in the pool.

## Description

### FIELD OF THE TECHNOLOGY

At least some embodiments disclosed herein relate to memory devices in general, and more particularly, but not limited to memory devices that perform memory management operations (e.g., wear leveling).

### BACKGROUND

Memory devices can include semiconductor circuits that provide electronic storage of data for a host system (e.g., a server or other computing device). Memory devices may be volatile or non-volatile. Volatile memory requires power to maintain data, and includes devices such as random-access memory (RAM), static random-access memory (SRAM), dynamic random-access memory (DRAM), or synchronous dynamic random-access memory (SDRAM), among others. Non-volatile memory can retain stored data when not powered, and includes devices such as flash memory, read-only memory (ROM), electrically erasable programmable ROM (EEPROM), erasable programmable ROM (EPROM), resistance variable memory, such as phase change random access memory (PCRAM), resistive random-access memory (RRAM), or magnetoresistive random access memory (MRAM), among others.

Host systems (e.g., a host device) can include a host processor, a first amount of host memory (e.g., main memory, often volatile memory, such as DRAM) to support the host processor, and one or more storage systems (e.g., non-volatile memory, such as flash memory) that provide additional storage to retain data in addition to or separate from the main memory.

A storage system, such as a solid-state drive (SSD), can include a memory controller and one or more memory devices, including a number of (e.g., multiple) dies or logical units (LUNs). In certain examples, each die can include a number of memory arrays and peripheral circuitry thereon, such as die logic or a die processor. The memory controller can include interface circuitry configured to communicate with a host device (e.g., the host processor or interface circuitry) through a communication interface (e.g., a bidirectional parallel or serial communication interface). The memory controller can, for example, receive commands or operations from the host system in association with memory operations or instructions, such as read or write operations to transfer data (e.g., user data and associated integrity data, such as error data or address data, etc.) between the memory devices and the host device, erase operations to erase data from the memory devices, perform drive management operations (e.g., data migration, garbage collection, block retirement), etc.

Many memory devices, particularly non-volatile memory devices, such as NAND flash devices, etc., frequently relocate data or otherwise manage data in the memory devices (e.g., garbage collection, wear leveling, drive management, etc.). NAND flash is a type of flash memory constructed using NAND logic gates. Alternatively, NOR flash is a type of flash memory constructed using NOR logic gates.

Volatile memory devices such as DRAM typically refresh stored data. For example, refresh is activating and then precharging a row. At activation time the data in the cells are sensed (implicitly read), and at precharge time the data is written back to the cells (implicitly written).

Storage devices can have controllers that receive data access requests from host computers and perform programmed computing tasks to implement the requests in ways that may be specific to the media and structure configured in the storage devices. In one example, a flash memory controller manages data stored in flash memory and communicates with a computing device. In some cases, flash memory controllers are used in solid-state drives for use in mobile devices, or in SD cards or similar media for use in digital cameras.

Firmware can be used to operate a flash memory controller for a particular storage device. In one example, when a computer system or device reads data from or writes data to a flash memory device, it communicates with the flash memory controller.

Although current memory technologies provide for various functionality and benefits, situations often arise that may potentially cause degradation to the memory devices, potential data loss, damage to memory cells of the memory devices, among potential harmful effects to the memory devices. For example, certain memory cells of a memory array may be the target of a disproportionate number of read operations, write operations, other operations, or a combination thereof, when compared to other memory cells of the memory array. In such instances, such memory cells may wear out faster than other less-frequently-used memory cells.

Various techniques exist for extending the life of memory cells and balancing memory usage in memory devices. For example, wear leveling is a memory management technique that can extend the useful life of the memory cells of a device by effectively spreading memory usage across the various sections of the memory array so that the sections experience comparable memory usage. Wear leveling, for example, may involve transferring data from source memory rows located in a section of a memory array to target rows that may be located in another section of the memory array and then mapping the addresses of the source memory rows to addresses corresponding to the target memory rows. Memory management technologies may be enhanced to reduce the amount of memory resources utilized to conduct memory management, reduce errors in data and error correction bits, and further extend the life of memory.

### BRIEF DESCRIPTION OF THE DRAWINGS

The embodiments are illustrated by way of example and not limitation in the figures of the accompanying drawings in which like references indicate similar elements.
**FIG. 1** shows a memory device that biases access lines (e.g., wordlines, digit lines, bitlines) to move data when performing wear leveling for memory cells in a memory array, in accordance with some embodiments.
**FIG. 2** shows a memory device that performs wear leveling using multiple gap locations in a pool, in accordance with some embodiments.
**FIG. 3** shows sense amplifier latches to hold data associated with memory cells of a memory array, in accordance with some embodiments.
**FIG. 4** shows a data path for read and write operations for a host device for each of multiple banks in a memory device, in accordance with some embodiments.
**FIGs. 5A-5E** show an example of a start-gap algorithm for a pool that uses a single gap location.
**FIG. 6** shows wear leveling for a pool using multiple gap locations with fixed spacing between gap locations, in accordance with some embodiments.
**FIG. 7** shows wear leveling for a pool using multiple gap locations with variable spacing between gap locations, in accordance with some embodiments.
**FIG. 8** shows wear leveling for a pool using multiple gap locations with a separate pointer to each gap location, in accordance with some embodiments.
**FIG. 9** shows a method for wear leveling using multiple gap locations in a pool, in accordance with some embodiments.

### SUMMARY

The invention is as defined in independent claims; optional embodiments are defined in dependent claims.

### DETAILED DESCRIPTION

The following disclosure describes various embodiments for performing memory management operations (e.g., wear leveling) using multiple gap locations in the same pool. At least some embodiments herein relate to a non-volatile memory device that includes a wear leveling manager (e.g., logic circuitry and/or firmware) for performing wear leveling using multiple gap locations in a single pool of memory cells in one or more memory arrays (e.g., the single pool is a memory management group such as a bank of a RAM). In some embodiments, a volatile memory device performs wear leveling using multiple gap locations in the same pool. These memory devices may, for example, store data used by a host device (e.g., a computing device of an autonomous vehicle, or another computing device that accesses data stored in the memory device). In one example, the memory device is a solid-state drive mounted in an electric vehicle.

Storage elements in a memory device may degrade and fail with use. In some cases, a memory device may implement an algebraic wear leveling scheme in order to mitigate wear and an on-die ECC scheme. This wear leveling scheme will adjust logical-to-physical address mapping for a wear leveling pool as part of performing the wear leveling. Each wear leveling pool requires specific circuitry to facilitate wear leveling movements and logical-to-physical address translation. In one example, a wear leveling pool is an individual bank.

In some cases, an on-die wear leveling algorithm for memory devices (e.g., DRAM, non-volatile RAM, or NOR flash memory) is based on a start-gap algorithm. The algorithm is used for a pool that is a set of memory locations (e.g., which store user data) in a memory array(s). The pool contains an additional location (referred to as a gap location, or sometimes as simply a gap) that moves (e.g., rolls or cycles) through the pool. Moving the gap location allows the memory device to remove the correlation between logical addresses of the user data and physical addresses in the memory at which the user data is stored. This distributes accesses to the physical memory evenly along the whole pool.

In one example, use of a start-gap algorithm manages the problem in which a user is repeatedly accessing the same memory address (e.g., physically accessing the same memory cells). Reading the same physical cells multiple times increases stress on the cells. Also, programming the same cells multiple times increases stress on the cells. In one example, a hacker may attempt to access a memory device by stressing cells in this manner. The hacker is trying to kill some of the memory cells (e.g., to breach a security system of a memory device). In one example, a hacker may try to kill certain cells that are storing privileged data. This is part of an attempt to improperly gain access to a secure system.

DRAM is typically more resistant against the above problem, but NOR, NAND, and non-volatile RAM are typically more susceptible to the above. For example, in NOR/NAND devices excessive accesses degrade the physical cells (and thus its capacity to store data), while for DRAM the data is lost but the physical cells do not wear out as much. The start-gap algorithm overcomes this problem by distributing the wear out across a larger set of cells by moving the user data to different physical cells. So, there is a remapping of the logical address used by the hacker to a regularly changing physical address of the cell.

A start-gap algorithm is applied to a pool of memory cells in a memory device. The larger the pool, the longer the lifetime of the memory device. The dimension of the pool is limited by the endurance of the memory technology used in the memory device (e.g., endurance as measured by a number of reads and/or writes to a given cell). The start-gap algorithm needs to move locations that are being heavily accessed before they wear out.

The gap location moves through locations in the pool. The gap location must move to reach the furthest position away from its starting location in the pool before any given memory cell wears out (e.g., due to repeated access by a hacker to a given logical address).

In one example, the gap location is moved every time a memory management (MM) command is received by a controller or other logic circuitry of the memory device. If Ψ is defined as the ratio between access commands and memory management commands, then the size of a suitable pool can be determined as follows: PoolSize < Endurance / Ψ.

A larger pool distributes memory accesses over a larger number of physical cells. This reduces the stress on each individual cell. If the pool size is too small, then this can cause the technical problem of shortened life duration for the memory device.

However, using a larger pool may present the technical problem of a memory cell dying before a single gap location moves through the entire dimension of the pool. Thus, the endurance of the physical memory cells in a pool may limit the size of the pool. As an example, consider that a memory cell at logical address 0 is repeatedly attacked by a hacker. This continues as the gap location moves through the pool. The gap location needs to move to address 0 (so that stored user data is moved) before the memory cell dies from the attack. The bigger the pool, the more time the stored user data must wait before being moved.

In one example, the gap location is moved every time a memory management command is received. Normal activity of the memory is suspended in order to move the gap. Moving the gap location requires copying the user data to be moved to a new physical address location, and changing start location and gap location pointers used in implementing the start-gap algorithm. The stored user data in memory is blocked and not accessible to a host while the foregoing is done.

In one example, the issuance of a memory management command can be based on time or activity. For example, memory management can be performed every 100 write commands. In one example, a memory die receives this command from a memory controller.

In one example, each physical memory cell has an endurance of receiving at most a million accesses. The pool size is 1,000 memory cells, and Ψ is 1,000. It is desired that Ψ is kept higher to avoid significantly degrading quality of service or bandwidth.

In one example, an algebraic-based wear leveling scheme (e.g., a start-gap algorithm such as discussed above) uses an additional row in a memory array to allow wear leveling movements. The wear leveling movements consist of moving source data (e.g., pointed to by a source pointer) to a target row (e.g., pointed to by a target pointer). A physical address is determined by adding a present or next offset to a logical address. Given a logical address, and assuming the target pointer and source pointer are maintained properly, then an algorithm permits determining the physical address. Source data at a source address is moved to a target address. The target pointer and source pointer are updated after each wear leveling movement. The offset pointer is regularly updated according to the movements.

In one example, wear leveling movements may be triggered by an activity-based (e.g., a refresh management (RFM) command for DRAM) or periodic memory management (MM) command (e.g., based on a repeating time interval). For example, each memory management command causes wear leveling movement to occur. The quantity of movement in a pool caused by an MM command is linked to the quantity of gap locations available. In one embodiment, a multiple memory management (MMM) command can be used that suspends and takes control of multiple banks and applies a memory management operation in each of multiple banks in parallel. In contrast, a single MM command applies to only one pool and suspends other memory activity on the bank in which the pool is located.

In one example, a memory device is a flash memory in an SSD, or a device using another memory technology having cells that sustain sufficient wear to require wear leveling to ensure sufficient lifetime. A wear leveling pool includes addresses that are cycled through wear leveling movements so that any given logical address (e.g., for stored user data) over time could be associated with any physical address in the pool. An activity-based refresh management command (RFM) for DRAM is used to trigger wear leveling movements. In one example, the wear leveling movement is broken up into two portions using a holding register. Data goes through an ECC scrub when being moved from a source address to the holding register. Data is then moved one code word at a time from the holding register to a target address.

In one example, before source data is written to a target row during wear leveling, an ECC scrub is performed on the source data. Scrubbing correctable errors during wear leveling prevents the accumulation of correctable errors that could aggregate into an uncorrectable error. Thus, scrubbing correctable errors during wear leveling reduces the likelihood of experiencing uncorrectable errors.

In one example, each bank in a memory device has its own wear-leveling engine, and multiple banks can be maintained in parallel. In one case, if a multiple memory management command is used, wear leveling occurs in parallel for several of the banks. A controller cannot access any of the data in any of the banks (e.g., within a bank group) while the scrub process for wear leveling is occurring.

Various embodiments of the present disclosure provide a technological solution to one or more of the above technical problems. In one embodiment, a wear leveling start-gap algorithm in a memory device uses multiple gap locations for a single pool. Using several gap locations per pool (instead of only a single gap location per pool as described above) permits, for example, optimizing the wear leveling algorithm for memory devices that use newer memory technologies (e.g., phase change memory using chalcogenide memory cells) for which intrinsic endurance is lower than for prior technologies (e.g., non-volatile RAM, SRAM). Using several gap locations in the same pool allows the use of larger pools, which provides a life duration benefit, while ensuring the memory cells in the pool don't die before being moved (e.g., as described above) as the gap locations cycle through the pool.

In one embodiment, a memory device has a memory array configured to store user data for a host device. A controller performs wear leveling for a pool of memory locations in the memory array using a start-gap algorithm that is implemented using a plurality of gap locations in the same pool. The memory device includes registers that store respective pointers for each of the gap locations. For example, the gap locations can be stored in a register, RAM, FIFO buffer, and/or other memory accessible by the controller.

The memory device also includes a register or other memory to store the start location of the pool. The start location is incremented after the last of the gap locations cycles through all memory locations in the pool. The gap locations can be moved by the same memory management command, or each gap location can be moved by a different memory management command.

In one embodiment, a memory device includes bias circuitry to apply voltages to access lines for accessing memory cells. For example, a processing device of a controller applies voltages to the access lines using the bias circuitry to provide access to a first physical memory location and a second physical memory location (e.g., memory cells accessed using an activated wordline).

In response to a memory management command, the controller manages a wear leveling pool by copying data from the first physical memory location to the second physical memory location. The second physical memory location is one of multiple unused memory locations (e.g., multiple gap locations) in the same pool.

After copying the data, the controller updates a pointer corresponding to moving of one or more of the unused memory locations (e.g., pointers are updated for moving of first and second gap locations in the pool). In one embodiment, the gap pointers are updated based on a number of the memory locations that are moved during the memory management operation initiated by the memory management command.

The unused memory locations are cycled through the set of physical memory locations in the wear leveling pool. For example, the start location is updated when the last of the unused memory locations completes a cycle through a fixed number or range (e.g., a defined range or subset of a pool) of the physical memory locations.

In one embodiment, each group of banks in a memory device contains its own ECC engine(s) (e.g., located at the edge of the bank group). The ECC engine(s) operates during standard read and write commands using a data path. The ECC engine(s) is also used to facilitate ECC scrubbing during wear leveling movements. The ECC engine(s) services reads and writes, and other memory management operations (e.g., scrubbing during wear leveling).

In one embodiment, a memory device has a controller that moves data from a source page to a target page during wear leveling. The data is updated as needed based on error correction of the data. The memory device includes error correction circuitry (e.g., wear-leveling ECC engine) to perform the error correction. After the error correction, the controller moves data to the target page.

In one embodiment, a code word ECC engine is used to detect and correct errors on a given code word. The code word consists of data and parity to be processed by the code word ECC engine. A scrub by the code word ECC engine is triggered by a memory management operation.

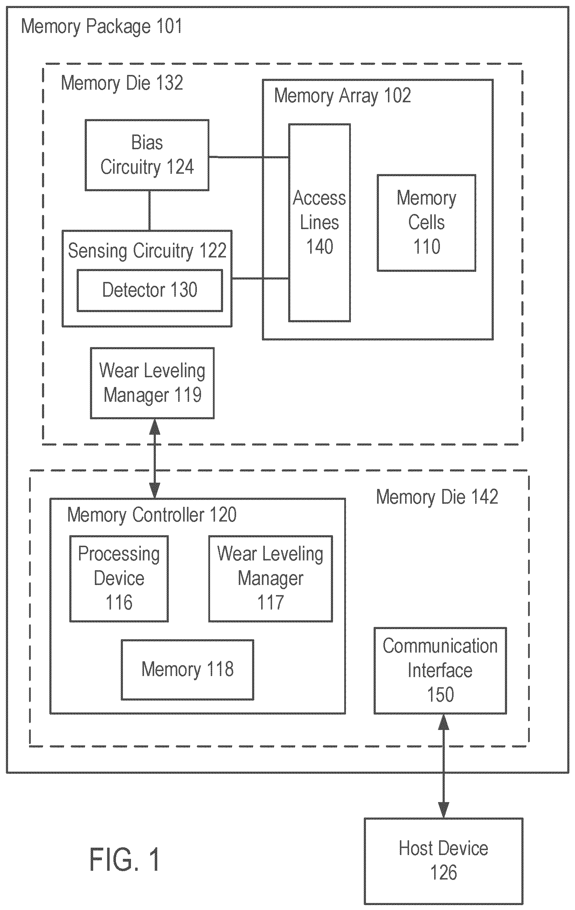

**FIG. 1** shows a memory device that biases access lines 140 (e.g., precharges wordlines or bitlines) to move data when performing wear leveling (e.g., using a start-gap algorithm with multiple gap locations in a pool) for memory cells 110 in a memory array 102, in accordance with some embodiments. In one example, the memory device precharges wordlines and/or bitlines in a precharging phase in preparation for sensing memory cells 110 in memory array 102. In one example, memory cells 110 are chalcogenide memory cells. In one example, controller 120 controls timing of turning on and off the precharging.

The memory device is configured as a memory package 101 encapsulating memory dies 132, 142. Each memory die 132 has a local wear leveling manager 119. Memory controller 120 of memory die 142 communicates with one or more memory die 132. Memory controller 120 includes wear leveling manager 117. Wear leveling using multiple gaps in a pool as described herein can be implemented by wear leveling manager 117 and/or wear leveling manager 119. Wear leveling manager 117, 119 can be implemented using logic circuitry, state machines, and/or firmware.

Sensing circuitry 122 senses a state of memory cells 110. Sensing circuitry 122 includes detector 130. In one example, detector 130 is a transistor, an inverter, or a differential amplifier. Memory cells 110 are selected using access lines 140. In one example, access lines 140 include wordlines and bitlines in a cross-point memory array.

Bias circuitry 124 biases selected ones of access lines 140 for selecting a portion of memory cells 110 to be sensed. Bias circuitry 124 also supplies power to sensing circuitry 122, including supplying power to detector 130.

Memory controller 120 controls various operations of the memory device, including read and write operations on memory cells 110. Memory controller 120 includes processing device 116 and memory 118. Some operations are controlled by controller 120 in response to various commands received from host device 126 on communication interface 150.

In one embodiment, communication interface 150 receives a read or write command from host device 126. In response to receiving the command, controller 120 initiates a read or write operation. For example, as part of a read operation, a memory cell 110 is selected to have its logic state determined by sensing circuitry 122.

Bias circuitry 124 drives voltages on access lines 140 to select the memory cell, including driving a voltage on a wordline or bitline used to select the memory cell. To sense the state of the memory cell, detector 130 monitors a voltage on the bitline.

In one embodiment, the voltage on the bitline is first driven to an initial voltage in a precharging phase using precharging circuitry. After the bitline reaches the initial voltage, the precharging is turned off. Then, detector 130 is used to detect whether the bitline voltage has been pulled down due to the memory cell 110 having reached a switching threshold. In other embodiments, a wordline or other access line may be precharged and sensed instead of, or in addition to, a bitline.

Detector 130 detects a change of voltage on a bitline caused by a memory cell switching. An output of detector 130 is used by sensing circuitry 122 to determine the logic state (e.g., 1 or 0) of the memory cell that has been read.

In one embodiment, memory cells 110 store user data for host device 126. Memory cells 110 store data in either a first logic state or a second logic state. In one example, bias circuitry 124 includes wordline and bitline drivers (not shown) to bias wordlines and bitlines of memory array 102.

Sensing circuitry 122 may include sense amplifiers for sensing a characteristic associated with memory cells of the memory array 102. The characteristic can be, for example, a voltage and/or current associated with a selected memory cell. In one embodiment, this characteristic is used by a controller to determine a time duration for a wear leveling operation as described below.

In one embodiment, controller 120 causes bias circuitry 124 to apply voltages to selected memory cells 110. In one example, the voltages are increasing magnitudes of voltage values (e.g., +2, +2.5, +3, +3.5, +4, +4.5, +5 V) separated by steps (e.g., 0.5 V steps).

In one embodiment, memory controller 120 includes one or more processing devices 116 and memory 118. In one example, memory 118 stores firmware executed by processing device 116 to select and apply the read voltages. Memory controller 120 can use bias circuitry 124 to generate voltages for applying read and other voltages (e.g., initial read and read retry). Bias circuitry 124 can also generate voltages for applying write voltages to memory cells 110 as part of programming operations (e.g., as used in wear leveling).

In one embodiment, if sensing circuitry 122 determines that the current for a memory cell is greater than a fixed threshold (e.g., a predetermined level of current), then memory controller 120 determines that the memory cell has switched (e.g., snapped).

In one embodiment, memory controller 120 receives a write command from host device 126. The write command is accompanied by data (e.g., user data of a user of host device 126) to be written to memory array 102. In response to receiving the write command, controller 120 initiates a programming operation.

In one example, the polarity of the read or write pulses may be either a first polarity or a second polarity. For example, a write pulse may apply a voltage to a memory cell in a first polarity (e.g., bitline at 6V and wordline at 0V).

In one example, circuits coupled to access lines to which memory cells may be coupled are used to provide read pulses (e.g., access line drivers included in decoder circuits). The circuits may be controlled by internal control signals provided by a control logic (e.g., controller 120). A read voltage or pulse may be a voltage applied to a memory cell for a period of time (e.g., 10-50 ns, 1-100 ns, 1 ns to 1 microsecond). In some embodiments, the read pulse may be a square pulse. In some embodiments, the read pulse may be a ramp, that is, a linearly-increasing voltage may be applied across the memory cell.

In one example, after being accessed (e.g., selected), a memory cell may be read, or sensed, by a sense component (e.g., sensing circuitry 122) to determine the stored state of the memory cell. For example, a voltage may be applied to the memory cell (using a wordline and bitline) and the presence of a resulting current may depend on the applied voltage and the threshold voltage of the memory cell. In some cases, more than one voltage may be applied. Additionally, if an applied voltage does not result in current flow, other voltages may be applied until a current is detected by the sense component.

By assessing the voltage that resulted in current flow, the stored logic state of the memory cell may be determined. In some cases, the voltage may be ramped up in magnitude until a current flow is detected (e.g., a memory cell turns on, switches on, conducts current, or becomes activated). A current may be applied to a memory cell, and the magnitude of the voltage to create the current may depend on the electrical resistance or the threshold voltage of the memory cell.

In some cases, the memory cell (e.g., a PCM cell) includes a material that changes its crystallographic configuration (e.g., between a crystalline phase and an amorphous phase), which in turn, determines a threshold voltage of the memory cell to store information. In other cases, the memory cell includes a material that remains in a crystallographic configuration (e.g., an amorphous phase) that may exhibit variable threshold voltages to store information.

The sense component may include various transistors or amplifiers in order to detect and amplify a difference in the signals. The detected logic state of the memory cell may then be output through a column decoder as output. In some cases, the sense component may be part of a column decoder or a row decoder.

At least some embodiments herein relate to memory devices that use bipolar operations for a memory array (e.g., for multi-level memory cells). In one example, bipolar select voltages are used to select memory cells of the memory array. In one example, the memory cells are arranged in a cross-point architecture. In one example, each memory cell is formed using a single select device. In one example, the select device includes a chalcogenide material that switches (e.g., snaps) when a sufficient voltage is applied across the memory cell.

In some cases, a memory device may include an array of memory cells arranged in a three-dimensional (3D) architecture, such as a cross-point architecture, to store the set of data. The memory cells in a cross-point architecture may, for example, represent a first logic state (e.g., a logic 1, a SET state) associated with a first set of threshold voltages, or a second logic state (e.g., a logic 0, a RESET state) associated with a second set of threshold voltages.

In other embodiments, the memory cells may be arranged in a three-dimensional (3D) vertical architecture. A 3D vertical architecture may include memory cells located at the crossing between a vertical access line (e.g., a bitline pillar), and each one of a plurality of second access lines (e.g., wordlines), formed in horizontal planes or decks parallel to each other.

More generally, an integrated circuit memory cell, such as a memory cell in a cross-point memory or a 3D vertical array, can be programmed to store data by the way of its state at a voltage applied across the memory cell. For example, if a memory cell is configured or programmed in such a state that allows a substantial current to pass the memory cell at a voltage in a predefined voltage region, the memory cell is considered to have been configured or programmed to store a first bit value (e.g., one or zero); and otherwise, the memory cell is storing a second bit value (e.g., zero or one).

Optionally, a memory cell can be configured or programmed to store more than one bit of data by being configured or programmed, for example, to have a threshold voltage in one of more than two separate voltage regions.

In one example, the threshold voltage of a memory cell is such that when the voltage applied across the memory cell is increased to above the threshold voltage, the memory cell switches by changing rapidly or abruptly, snapping (e.g., for a chalcogenide memory cell), or jumping from a non-conductive state to a conductive state. The non-conductive state allows a small leak current to go through the memory cell; and in contrast, the conductive state allows more than a threshold amount of current to go through. Thus, a memory device can use a detector (e.g., a sense amplifier) to detect the change, or determine the conductive/non-conductive state of the memory device at one or more applied voltages, to evaluate or classify the level of the threshold voltage of the memory cell and thus its stored data.

For example, a memory cell in memory array 102 can be configured or programmed to store a one-bit data item in a Single Level Cell (SLC) mode, or a two-bit data item in a Multi-Level Cell (MLC) mode, or a three-bit data item in a Triple Level Cell (TLC) mode, or a four-bit data item in Quad-Level Cell (QLC) mode.

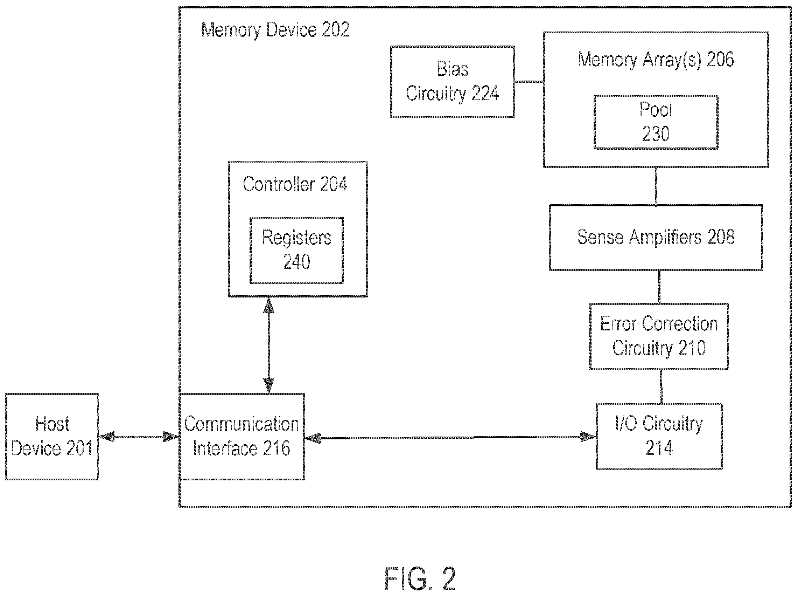

**FIG. 2** shows a memory device 202 that performs wear leveling using multiple gap locations in a pool 230, in accordance with some embodiments. In one example, pool 230 is a portion of memory array 206 (e.g., having a size of 25% of a bank). In one example, memory array 206 has a total of eight banks. User data is stored in one or more of the memory arrays 206. Bias circuitry 224 applies voltages to access lines of memory arrays 206. In one example, bias circuitry 224 activates a wordline in memory array 206.

Controller 204 implements wear leveling management using registers 240. Wear leveling for a set of memory locations in pool 230 of memory array 206 can be managed using a start-gap algorithm with multiple gap locations in the pool 230. In one embodiment, pool 230 includes memory to store data (e.g., start location, gap location spacings or offsets, size) regarding a pool of memory cells of memory array 206 to which wear leveling is applied. Registers 240 store a pointer to a start location of pool 230 and store one or more pointers to the multiple gap locations. In one embodiment, controller 204 uses data stored in registers 240 for determining physical address locations in the pool based on logical addresses received from host device 201. For example, only start location and gap locations information is needed to determine the physical address from the logical address when using the start-gap algorithm described herein. This provides a very light translation table.

In one example, controller 204 implements wear leveling manager 117. Controller 204 is an example of memory controller 120. Memory arrays 206 are an example of memory array 102.

In one embodiment, error correction circuitry 210 services memory management operations performed on data stored in memory array(s) 206. Portions of data from memory array 206 are copied to a temporary storage (e.g., buffer) during servicing (e.g., wear leveling). In one example, the temporary storage includes holding registers. In one example, error correction circuitry 210 includes a wear leveling ECC engine.

Error correction circuitry 210 services read and write operations. For example, the read or write operations are performed in response to commands or other signals received from host device 201.

Controller 204 accesses portions of memory array(s) 206 in response to commands received from host device 201 via communication interface 216. Sense amplifiers 208 sense data stored in memory cells of memory arrays 206. Controller 204 accesses the stored data by activating one or more rows of memory arrays 206. In one example, the activated rows correspond to a page of stored data. In one example, controller 204 receives a memory management command from host device 201 via communication interface 216.

When a row of memory array 206 is activated, data can be read from the row as part of a read or other operation (e.g., wear leveling). Error correction circuitry 210 is used to detect and correct any errors identified in the accessed data on the row (e.g., for a read requested by host device 201). Corrected read data is provided for output on communication interface 216 by I/O circuitry 214.

In one embodiment, communication interface (I/F) 216 is a bi-directional parallel or serial communication interface. The host device 201 can include a host processor (e.g., a host central processing unit (CPU) or other processor or processing circuitry, such as a memory management unit (MMU), interface circuitry, etc.).

In one embodiment, memory arrays 206 can be configured in a number of non-volatile memory devices (e.g., dies or LUNs), such as one or more stacked flash memory devices each including non-volatile memory (NVM) having one or more groups of non-volatile memory cells and a local device controller or other periphery circuitry thereon (e.g., device logic, etc.), and controlled by controller 204 over an internal storage-system communication interface (e.g., an Open NAND Flash Interface (ONFI) bus, etc.) separate from the communication interface 216.

In one embodiment, each memory cell in a NOR, NAND, 3D cross point, MRAM, or one or more other architecture semiconductor memory array 206 can be programmed individually or collectively to one or a number of programmed states. A single-level cell (SLC) can represent one bit of data per cell in one of two programmed states (e.g., 1 or 0). A multi-level cell (MLC) can represent two or more bits of data per cell in a number of programmed states (e.g., 2ⁿ, where n is the number of bits of data). In certain examples, MLC can refer to a memory cell that can store two bits of data in one of 4 programmed states. A triple-level cell (TLC) can represent three bits of data per cell in one of 8 programmed states. A quad-level cell (QLC) can represent four bits of data per cell in one of 16 programmed states. In other examples, MLC can refer to any memory cell that can store more than one bit of data per cell, including TLC and QLC, etc.

The controller 204 can receive instructions from the host device 201, and can transfer data to (e.g., write or erase) or from (e.g., read) one or more of the memory cells of the memory arrays 206. The controller 204 can include, among other things, circuitry or firmware, such as a number of components or integrated circuits. For example, the controller 204 can include one or more memory control units, circuits, or components configured to control access across the memory array and to provide a translation layer between the host device 201 and a storage system, such as a memory manager, one or more memory management tables, etc.

In one embodiment, controller 204 can include circuitry or firmware, such as a number of components or integrated circuits associated with various memory management functions, including, among other functions, wear leveling, error detection or correction, bank or block retirement, or one or more other memory management functions.

In one embodiment, controller 204 can include a set of management tables configured to maintain various information associated with one or more components of memory device 202 (e.g., various information associated with pool 230, memory array 206, and/or one or more memory cells coupled to controller 204). For example, the management tables can include information regarding bank or block age, block erase count, error history, or one or more error counts (e.g., a write operation error count, a read bit error count, a read operation error count, an erase error count, etc.) for one or more banks or blocks of memory cells coupled to the controller 204. In certain examples, if the number of detected errors for one or more of the error counts is above a threshold, the bit error can be referred to as an uncorrectable bit error. The management tables can maintain a count of correctable or uncorrectable bit errors, among other things.

In one embodiment, memory device 202 can include one or more three-dimensional (e.g., 3D NAND) architecture semiconductor memory arrays 206. The memory arrays 206 can include a number of memory cells arranged in, for example, banks, a number of devices, planes, blocks, physical pages, super blocks, or super pages. As one example, a TLC memory device can include 18,592 bytes (B) of data per page, 1536 pages per block, 548 blocks per plane, and 4 planes per device.

In one embodiment, data can be written to or read from the memory device 202 in pages. However, one or more memory operations (e.g., read, write, erase, etc.) can be performed on larger or smaller groups of memory cells, as desired. For example, a partial update of tagged data from an offload unit can be collected during data migration or garbage collection to ensure it was re-written efficiently.

In one example, a page of data includes a number of bytes of user data (e.g., a data payload) and its corresponding metadata. As an example, a page of data may include 4 kB of user data as well as a number of bytes (e.g., 32B, 54B, 224B, etc.) of auxiliary or metadata corresponding to the user data, such as integrity data (e.g., error detecting or correcting code data), address data (e.g., logical address data, etc.), or other metadata associated with the user data. Different types of memory cells or memory arrays can provide for different page sizes, or may require different amounts of metadata associated therewith.

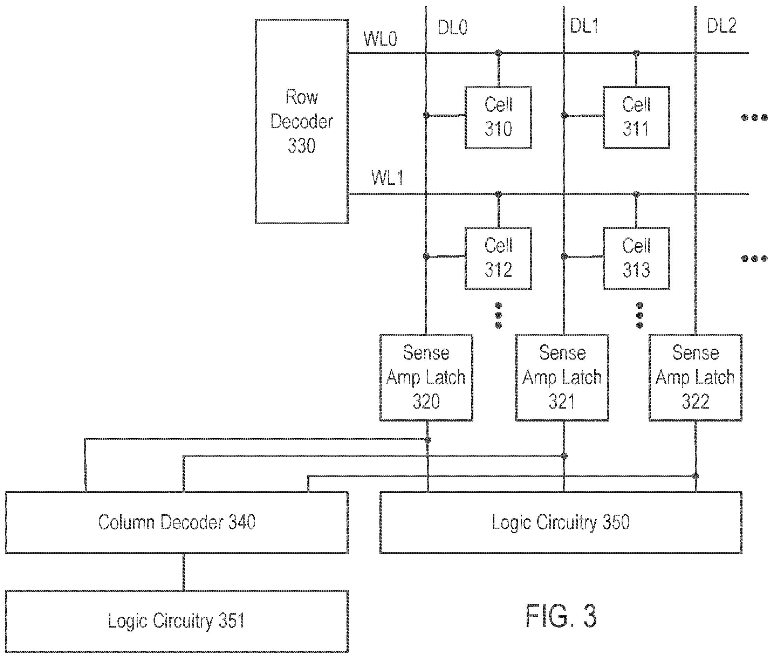

**FIG. 3** shows sense amplifier latches 320, 321, 322 to hold data associated with memory cells 310, 311, 312, 313 of a memory array, in accordance with some embodiments. In one example, the memory cells are located in memory array 102, 206. The memory cells can be of various memory types including volatile and/or non-volatile memory cells.

The memory cells are accessed using wordlines (e.g., WL0) and digit lines (e.g., DL0) or bit lines. An individual memory cell is accessed by activating a wordline selected by row decoder 330 and selecting a digit line or bit line selected by column decoder 340. When a wordline is activated, data from each memory cell on a row goes from the cell to the corresponding sense amplifier latch for each digit line or bit line.

Data residing in the sense amplifier latches can be used as inputs to logic circuitry 350, 351 for various computations. These can include using parity or other metadata stored with the memory cells to detect and/or correct errors in the data retrieved from the memory cells. In one embodiment, logic circuitry 350 includes error correction circuitry 210. In one example, logic circuitry 350 is arbitrary logic that operates on data at the page level.

Logic circuitry 351 is coupled to column decoder 340. In one embodiment, logic circuitry 351 includes error correction circuitry 210. In one example, logic circuitry 351 is arbitrary logic that operates on data at the column (e.g., code word) level (e.g., using an ECC engine).

In one embodiment, a memory device including a memory array has a plurality of memory cells 310, 311, 312, 313, etc., and one or more circuits or components to provide communication with, or perform one or more memory operations on, the memory array. A single memory array or additional memory arrays, dies, or LUNs can be used. The memory device can include row decoder 330, column decoder 340, sense amplifiers, a page buffer, a selector, an input/output (I/O) circuit, and a controller.

In some non-volatile memory devices (e.g., NAND flash), the memory cells of the memory array can be arranged in blocks. Each block can include sub-blocks. Each sub-block can include a number of physical pages, each page including a number of memory cells. In some examples, the memory cells can be arranged in a number of rows, columns, pages, sub-blocks, blocks, etc., and accessed using, for example, access lines, data lines, or one or more select gates, source lines, etc.

In volatile memory devices (e.g., DRAM) and some emerging non-volatile memory technologies, the memory cells of the memory array can be arranged in banks or other forms of partition. In one example, when an activate to a row address is issued, the row address may be addressed by addressing bits on the activate command using a bank address (to specify which bank within the memory device), and a row address (to specify which row within the specified bank). The wordline associated with the row address is brought high.

A controller (e.g., controller 204) can control memory operations of the memory device according to one or more signals or instructions received on control lines (e.g., from host device 201) including, for example, one or more clock signals or control signals that indicate a desired operation (e.g., write, read, erase, etc.), or address signals (A0-AX) received on one or more address lines. One or more devices external to the memory device can control the values of the control signals on the control lines, or the address signals on the address line. Examples of devices external to the memory device can include, but are not limited to, a host, a memory controller, a processor, or one or more circuits or components.

The memory device can use access lines and data lines to transfer data to (e.g., write or erase) or from (e.g., read) one or more of the memory cells (e.g., when moving user data in wear leveling). The row decoder and the column decoder can receive and decode the address signals (A0-AX) from the address line, can determine which of the memory cells are to be accessed, and can provide signals to one or more of the access lines (e.g., one or more of a plurality of wordlines (e.g., WL0-WLm)) or the data lines (e.g., one or more of a plurality of bit lines (BL0-BLn).

The memory device can include sense circuitry, such as sense amplifiers 208, configured to determine the values of data on (e.g., read), or to determine the values of data to be written to, the memory cells using the data lines. In one example, sense amplifiers are used to sense voltage (e.g., in the case of charge sharing in DRAM). In one example, in selected memory cells, one or more of the sense amplifiers can read a logic level in the selected memory cell in response to a read current flowing in the memory array through the selected cell(s) to the data line(s).

One or more devices external to the memory device can communicate with the memory device using I/O lines (e.g., DQ0-DQN), address lines (e.g., A0-AX), or control lines. I/O circuitry (e.g., 214) can transfer values of data in or out of the memory device, such as in or out of the page buffer or the memory array, using the I/O lines, according to, for example, the control lines and address lines. The page buffer can store data received from the one or more devices external to the memory device before the data is programmed into relevant portions of the memory array, or can store data read from the memory array before the data is transmitted to the one or more devices external to the memory device.

The column decoder 340 can receive and decode address signals (e.g., A0-AX) into one or more column select signals (e.g., CSEL1-CSELn). The selector (e.g., a select circuit) can receive the column select signals (CSEL1-CSELn) and select data in the page buffer representing values of data to be read from or to be programmed into memory cells. Selected data can be transferred between the page buffer and the I/O circuitry.

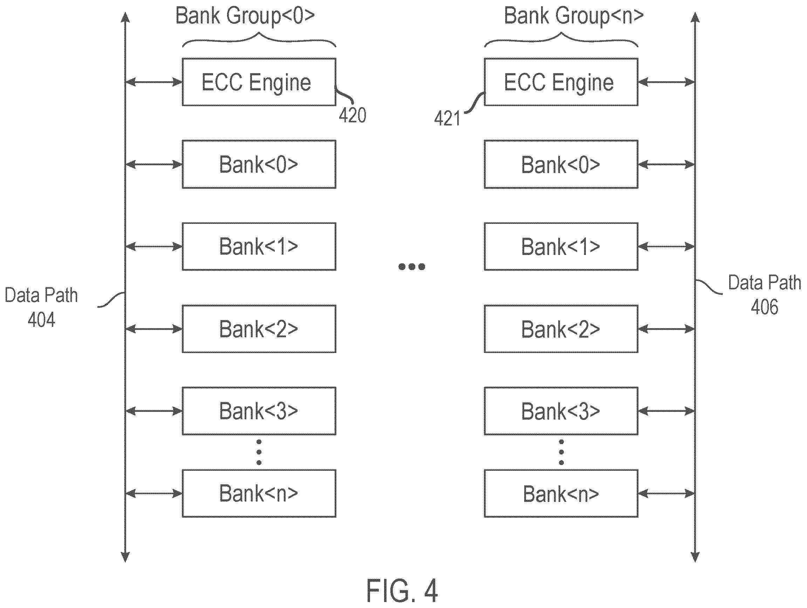

**FIG. 4** shows a data path 404, 406 for read and write operations for a host device (e.g., 201) for each of multiple banks in a memory device, in accordance with some embodiments. The banks can be arranged in bank groups (e.g., any number "n" of bank groups as indicated by "Bank Group <n>").

Data path 404, 406 is an example of a data path including I/O circuitry 214 and communication interface 216. In one embodiment, each bank group has an associated ECC engine 420, 421. ECC engines 420, 421 service read and write operations on data paths 404, 406. ECC engines 420, 421 are an example of error correction circuitry 210.

In some embodiments, to reduce total scrub time, there may be multiple ECC engines that exist on the memory device to allow multiple banks to be scrubbed in parallel. For example, a memory device may contain four bank groups and four ECC engines. In this case, each bank group is associated with its own ECC engine. A memory management group may contain subset of banks that may exist across one or more bank groups.

In one example, each page of a bank consists of code words or columns. The page is the set of specific memory cells that are activated when an activate command is issued. An activate command has a bank address as well as a row address.

In one embodiment, each bank group is coupled to a particular data path for that bank group. In one example, a data path is 100 bits wide.

In one example, a particular memory die may have many memory management groups. A memory management command is issued to a specific memory management group. This causes a memory management operation to occur for all banks in the group. The group is coupled to an ECC engine(s). A controller iterates through each bank in the group. In one example, the standard data bus for a memory device is a bi-directional bus.

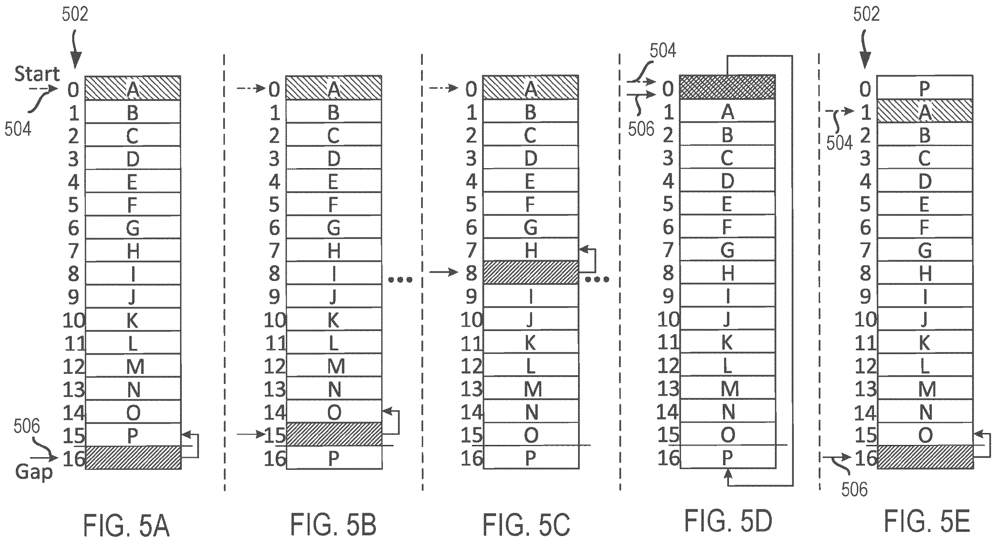

**FIGs. 5A-5E** show an example of a start-gap algorithm for a pool that uses a single gap location. The pool includes memory cells located at physical addresses 502 (e.g., 0-16). Physical addresses 502 correspond to memory locations in the pool at which user data (e.g., A-P) may be stored. One of the memory locations is not used for storing user data. Instead, the unused memory location is a gap location 506 that is moved through the pool as wear leveling is performed in response to memory management commands.

The first user data is entered into the pool at a start location 504. Gap location 506 starts at, for example, physical address 16. Gap location 506 is decremented as each data move is performed, as illustrated. When gap location 506 completes a full cycle through the pool, start location 504 is incremented to the next address as illustrated in **FIG. 5E****.**

As an example illustrated in **FIG. 5A****,** user data A-P can be considered stored at logical addresses 0-15. For example, user data A is stored at logical address 0, and user data P is stored at logical address 15.

When a first wear leveling operation is performed, user data P is copied or moved from physical address 15 to physical address 16, as illustrated in **FIG. 5B****.** After the data is moved, a pointer to the gap location is decremented to physical address 15. For example, user data P has logical address 15 (from the user/host perspective), but is stored at physical address 16 after being moved.

After several wear leveling operations have been performed, as illustrated in **FIG. 5C****,** user data H stored at physical address 7 is moved to the gap location at physical address 8. The pointer to the gap location is decremented to physical address 7.

In general, the physical addresses at which user data is stored can be determined based on comparing the logical address of the user data to the gap location. If the logical address of user data is after the gap location, the logical address is incremented by one to determine the physical address. If the logical address of user data is before the gap location, the logical address is incremented by zero to determine the physical address. The logical address is also adjusted by the value of the start location to determine the physical address.

Eventually, as illustrated in **FIG. 5D**, the gap location 506 reaches the start location 504. User data P is moved from physical address 16 to physical address 0. The gap location 506 is moved from physical address 0 to physical address 16. Because the application has completed a full cycle through the pool, the pointer to start location 504 is incremented by one so that the start location 504 is at physical address 1, as illustrated in **FIG. 5E****.**

As illustrated in **FIG. 5E****,** the next cycle for the gap location 506 begins by moving the gap location 506 from physical address 16 to physical address 15. User data O is moved to physical address 16.

In one example, the physical address of the stored user data is determined based on a logical address of the data, start location 504, and a comparison of the logical address to the gap location 506 (e.g., the logical address 14 for user data O is added to start location 1 and incremented by 1 due to being located after the gap location 506 to provide a physical address of 14+1+1=16) (note this is not shown in **FIG. 5E****).**

As described above, the start-gap algorithm moves stored data to different physical addresses in a pool to distribute wear. The gap location address is not available to the user. The start location and this gap permit moving the data. For example, both start and gap addresses are hidden to the user (e.g., hacker) to avoid allowing the user/hacker to follow the position of an attacked physical cell.

In one example, a pool has physical addresses 0-16. A host/user has programmed data A to P into logical addresses 0-15. For wear leveling, data P is first moved by copying into physical address 16. Then, the controller changes the address mapping for data P. Logical address 15 of user data P now points to physical address 16 in the pool. So, when the host/user reads logical address 15, the data is accessed from physical address 16.

In one example, two counters are used: one is a start counter, the other is a gap counter. The start counter indicates a level of cycling of the gap through the pool. Once the gap moves to physical address 0, the start counter is moved/increased because the gap has moved through a full cycle.

In one example, the start counter indicates the initial or first physical position of the user data. The controller determines the association between the logical address and the physical address using the start and gap counters along with logic circuitry (e.g., adders). In one example, a memory device has multiple pools that are being managed.

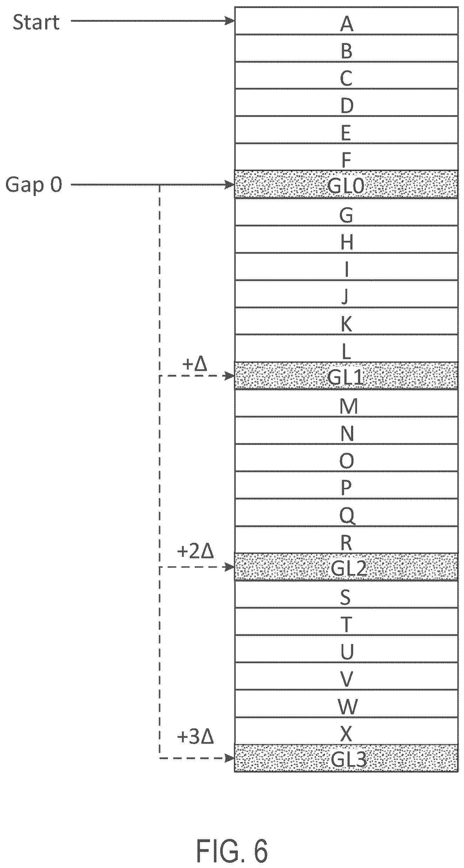

**FIG. 6** shows wear leveling using multiple gap locations per pool with a fixed delta spacing between gap locations, in accordance with some embodiments. For example, the illustrated four gap locations (e.g., GL0, GL1, GL2, GL3) are separated by a fixed offset or delta (e.g., gap locations determined as first gap location +Δ, first gap location +2Δ, first gap location +3Δ, as illustrated).

The illustrated pool stores user data A-X. The illustrated pool includes four gap locations. The illustrated pool is an example of pool 230. In one example, the location of the pointer to gap location gap 0 is stored in register 240.

In one embodiment, a single pointer is stored for the first gap location (gap 0). When a memory management command is received, the other three gap locations can be determined based on the multiples of offset from the first application, as illustrated. In one embodiment, a controller uses a single gap register to manage all the gap locations (GLs) of the pool. In one embodiment, all the gap locations of the pool are moved by the same memory management command.

When using multiple gap locations as illustrated, the start location is incremented similarly as discussed above. It should be noted that each gap location cycles through the entire or overall pool. The start location is incremented when, for example, gap 3 (GL3) completes a cycle which all of user data A-X is moved.

In one embodiment, the calculation of logical-to-physical address mapping uses a similar principle as for the start-gap algorithm for a pool using a single gap location above. However, when performing the logical-to-physical address mapping, instead of comparing the logical address with a single gap location value, the logical address is compared with multiple (e.g., four) gap location values.

The pool size when using multiple gap locations per pool can be increased as compared to the pool size when using a single gap location as described above. The pool size is now given by the following:
PoolSize < Endurance * NbGLperPool / Ψ, where NbGLperPool is the number of gap locations per pool.

In one embodiment, the gap locations are evenly distributed in the pool. In one embodiment, gap locations may be unevenly distributed. However, this may be less optimal as the largest gap (Δmax) will be the limiting factor on the size of the pool. The maximum delta is given by: Δmax < endurance / Ψ.

For a pool with distributed gap locations, the limitation on sizing is the distance between a gap location and the furthest address to which the gap location must move to complete a cycle. Staying within the maximum delta (Δmax) ensures each respective gap location reaches the furthest address before the corresponding physical cell dies from repeated stressing due to accessing the cell.

In one embodiment, a single register is used to manage all gap locations. Movement of all gap locations needs to be handled with a single memory management command. In one embodiment, movement of data corresponding to all gap locations is handled using faster write commands (e.g., operating in a memory mode using burst or stream commands). In one example, user data F, L, R, X are moved in response to the single memory management command. Then, the pointer to gap 0 is incremented.

The use of a single wear leveling command instead of four separate commands can reduce command bus utilization in some cases. The gap locations are moved at the same time because of the use of the fixed spacing and a single register. When using a single memory management command, there is typically less time to move the gap locations. In one embodiment, a wear leveling operation can be performed more quickly when done using an internal wear leveling machine instead of firmware. This can result in a higher availability of the memory device and/or controller.

An advantage of using multiple gap locations per pool is the ability to increase the size of the pool. For example, the pool size can be increased by a factor of four when using four gaps, as illustrated in **FIG. 6****.**

The start counter contains the address of the first user data added to the pool. The single gap counter contains the address of the gap location (Gap 0). In an alternative embodiment, with four gap locations, four different gap counters can be used. In the illustrated case, the gap locations are always maintained at the same distance delta from one another. The delta can be a fixed constant, or the delta can be varied by the controller in other embodiments.

In one example, a logical-to-physical address mapping is determined based on whether a logical address is before or after each gap location. With four gaps as illustrated, a wear leveling manager does four comparisons of the logical address to each of the four gap locations. The physical address is determined by incrementing the logical address based on the number of comparisons in which the logical address is after the respective gap location.

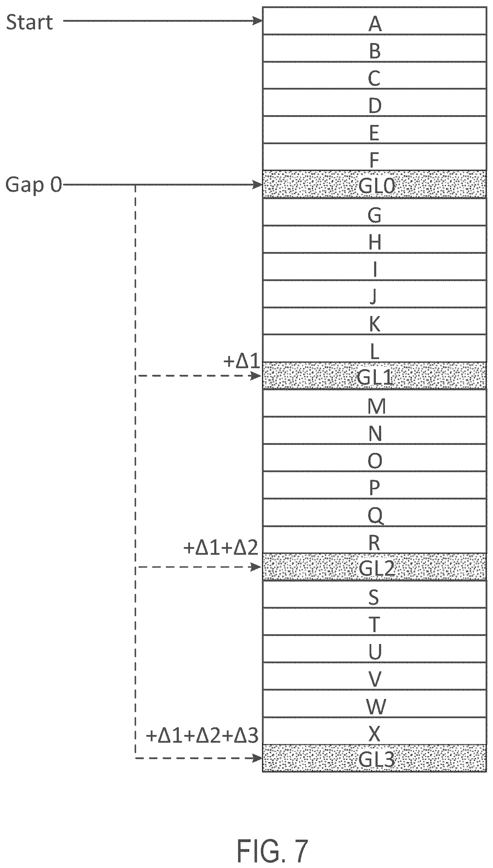

**FIG. 7** shows wear leveling for a pool using multiple gap locations with variable spacing between gap locations (e.g., different delta spacing between gap locations with values of Δ1, Δ2, Δ3), in accordance with some embodiments. The delta spacing values of Δ1, Δ2, Δ3 are different, and each value is saved by the controller in a register or other memory.

A single counter is used for storing the first gap location (Gap 0). The other gap locations are determined based on offset from the first application as determined by the saved delta spacing values. Wear leveling for the pool of **FIG. 7** is otherwise managed similarly to wear leveling for the pool of **FIG. 6****.**

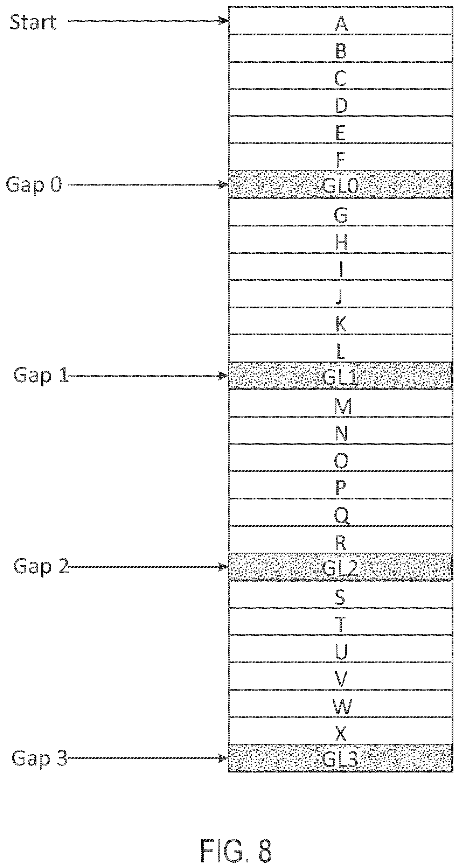

**FIG. 8** shows wear leveling for a pool using multiple gap locations with a separate pointer to each gap location (e.g., Gap 0, Gap 1, Gap 2, Gap 3), in accordance with some embodiments. This approach provides more flexibility in that it allows a controller to manage the four gap locations in multiple different memory management commands (e.g., four different commands). Wear leveling for the pool of **FIG. 8** is otherwise managed similarly to wear leveling for the pool of **FIG. 6****.**

In one example, a controller uses four separate counters. Each gap location has a location stored by a different counter.

In one embodiment, gaps are moved in response to different commands. For example, a controller moves Gap 0 on the first memory management command, then moves Gap 1 on the second memory management command, etc. Then, the controller goes back and moves Gap 0 again on another memory management command.

This approach allows the controller to modulate the time duration for performing an operation in response to a command by handling a number of gap locations that varies with each command. The controller can modulate the duration based on a context of the memory device. For example, a single gap location can be moved during heavy traffic, while 2-4 gap locations can be moved during idle time. In one embodiment, the time duration is adjusted to permit moving of the selected number of gap locations to move.

In one embodiment, the context can be determined by a controller based on characteristics of one or more memory cells in an array (e.g., cells storing data to be moved, or cells in a same pool as cells storing data to be moved). In one example, the characteristics include read or write performance or timing, and/or error rate during reads.

The memory management command can indicate a number of gap locations to be moved based on current operating conditions. In one example, the host or controller determines an extent of traffic by examining a queue of commands. In one example, the host or controller determines the length of the queue. In one example, the host or controller determines a number and/or type of commands waiting for action. Based on the foregoing factors, the host or controller determines the number of gap locations to be moved in response to the memory management command.

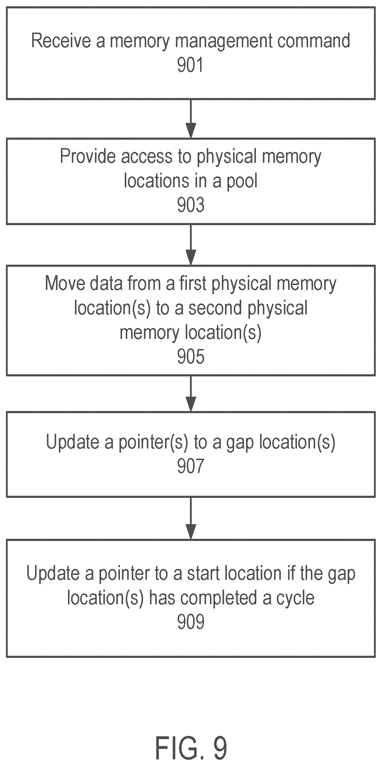

**FIG. 9** shows a method for wear leveling using multiple gap locations in a pool, in accordance with some embodiments. For example, the method of **FIG. 9** can be implemented in the memory device 202 of **FIG. 2****.**

The method of **FIG. 9** can be performed by processing logic that can include hardware (e.g., processing device, circuitry, dedicated logic, programmable logic, microcode, hardware of a device, integrated circuit, etc.), software (e.g., instructions run or executed on a processing device), or a combination thereof. In some embodiments, the method of **FIG. 9** is performed at least in part by one or more processing devices (e.g., controller 120 of **FIG. 1**) and/or by logic circuitry.

Although shown in a particular sequence or order, unless otherwise specified, the order of the processes can be modified. Thus, the illustrated embodiments should be understood only as examples, and the illustrated processes can be performed in a different order, and some processes can be performed in parallel. Additionally, one or more processes can be omitted in various embodiments. Thus, not all processes are required in every embodiment. Other process flows are possible.

At block 901, a memory management command is received. In one example, the command is received by wear leveling manager 119 from memory controller 120. In one example, the command is received by memory controller 120 from host device 126.

At block 903, access is provided to physical memory locations in a pool. In one example, bias circuitry 124 applies voltages to access lines 140 to provide access to memory cells storing user data.

At block 905, data is moved from one or more first physical memory locations to one or more second physical memory locations. In one example, user data F, L, R, X of **FIG. 6****,** **7****, or** **8** is moved in response to the memory management command.

At block 907, one or more pointers to gap locations are updated. In one example, a pointer to Gap 2 of **FIG. 8** is updated after moving user data R.

At block 909, a pointer to a start location is updated if the one or more gap applications has completed a cycle. In one example, a pointer to a start location of pool 230 is updated.

In some aspects, the techniques described herein relate to an apparatus including: at least one memory array (e.g., 102, 206); and at least one controller (e.g., 120, 204) configured to perform wear leveling for a pool of memory locations in the memory array using a plurality of gap locations in a same pool (e.g., 230).

In some aspects, the techniques described herein relate to an apparatus, wherein the controller is further configured to move at least one of the gap locations in response to receiving a memory management command.

In some aspects, the techniques described herein relate to an apparatus, wherein an indication is provided with the memory management command indicating a number of the gap locations to be moved.

In some aspects, the techniques described herein relate to an apparatus, wherein the gap locations are separated by a fixed offset (e.g., gap locations determined as first gap location +Δ, first gap location +2Δ, first gap location +3Δ).

In some aspects, the techniques described herein relate to an apparatus, wherein the controller is further configured to move all of the gap locations in a same pool in response to a single memory management command.

In some aspects, the techniques described herein relate to an apparatus, further including registers configured to store respective pointers for each of the gap locations (e.g., store gap locations in a register, RAM, FIFO buffer, or other memory).

In some aspects, the techniques described herein relate to an apparatus, further including a register (e.g., 240) configured to store a start location, wherein the wear leveling is performed further using the start location.

In some aspects, the techniques described herein relate to an apparatus, further including a register (e.g., 240) configured to store a first gap location, wherein at least one second gap location is determined using the first gap location (e.g., second and third gap locations are determined based on offsets from the first gap location).

In some aspects, the techniques described herein relate to a method including: determining a context (e.g., length of a command queue, extent of resource utilization by a memory device) of a memory device configured to perform memory management using multiple gaps in a single pool; and modulating a time duration based on the determined context, wherein at least one of the gaps is moved within the time duration.

In some aspects, the techniques described herein relate to a method, wherein a number of gaps to be moved is based on the determined context.

In some aspects, the techniques described herein relate to a method, wherein a pointer for each moved gap is decremented.

In general, gap locations and start locations move in opposite directions. Start and gap locations are updated after user data movement. In general, the update can be either an increment or a decrement, as long as start and gap locations are incremented/decremented oppositely in a manner that corresponds to this movement in opposite directions.

In some aspects, the techniques described herein relate to a method, wherein the determined context is based on a number of pending commands in a queue.

In some aspects, the techniques described herein relate to a method, wherein the memory device includes a memory array, and the determined context is based on a characteristic of at least one memory cell in the memory array.

In some aspects, the techniques described herein relate to a system including: bias circuitry (e.g., 124, 224); a plurality of access lines (e.g., 140); and at least one processing device (e.g., 116) configured to: apply at least one voltage to at least one of the access lines using the bias circuitry to provide access to a first physical memory location and a second physical memory location (e.g., memory cells accessed using an activated wordline); copy data (e.g., user data P at logical address 15) from the first physical memory location (e.g., physical address 15) to the second physical memory location (e.g., physical address 16), wherein the second physical memory location is one of a plurality of unused memory locations (e.g., multiple gap locations); and update, based on copying the data, a pointer corresponding to moving of a first unused memory location.

In some aspects, the techniques described herein relate to a system, wherein copying the data includes using a burst or stream mode to write the data.

In some aspects, the techniques described herein relate to a system, wherein the unused memory locations are cycled through a set of physical memory locations (e.g., the set of memory locations is a wear leveling pool), and a start location is updated when the first unused memory location completes a cycle through the entire pool (e.g., locations of user data A-X) .

In some aspects, the techniques described herein relate to a system, further including registers configured to store each of the unused memory locations (e.g., store each of multiple gap locations).

In some aspects, the techniques described herein relate to a system, wherein the processing device is further configured to receive a memory management command, the data is copied in response to receiving the memory management command, and a pointer to a start location is updated in response to the last unused memory location completing a cycle. In some cases, all gap locations complete a cycle at the same time.

In some aspects, the techniques described herein relate to a system, wherein the first unused memory location is a first gap location, and the processing device is further configured to: determine a physical address of the second physical memory location based on a logical address of the data, a start location, and a comparison of the logical address to at least one gap location (e.g., logical address 14 for user data O is added to a start location 1 and incremented by 1 due to being located after a first gap location to provide a physical address of 14+1+1=16); and update the start location in response to the first gap location completing a cycle.

In some aspects, the techniques described herein relate to a system, wherein the processing device is further configured to determine a logical-to-physical address mapping by comparing a logical address of the data to a plurality of gap locations.

The disclosure includes various devices which perform the methods and implement the systems described above, including data processing systems which perform these methods, and computer-readable media containing instructions which when executed on data processing systems cause the systems to perform these methods.

The description and drawings are illustrative and are not to be construed as limiting. Numerous specific details are described to provide a thorough understanding. However, in certain instances, well-known or conventional details are not described in order to avoid obscuring the description. References to one or an embodiment in the present disclosure are not necessarily references to the same embodiment; and, such references mean at least one.

As used herein, "coupled to" or "coupled with" generally refers to a connection between components, which can be an indirect communicative connection or direct communicative connection (e.g., without intervening components), whether wired or wireless, including connections such as electrical, optical, magnetic, etc.

Reference in this specification to "one embodiment" or "an embodiment" means that a particular feature, structure, or characteristic described in connection with the embodiment is included in at least one embodiment of the disclosure. The appearances of the phrase "in one embodiment" in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not other embodiments.

In this description, various functions and/or operations may be described as being performed by or caused by software code to simplify description. However, those skilled in the art will recognize what is meant by such expressions is that the functions and/or operations result from execution of the code by one or more processing devices, such as a microprocessor, Application-Specific Integrated Circuit (ASIC), graphics processor, and/or a Field-Programmable Gate Array (FPGA). Alternatively, or in combination, the functions and operations can be implemented using special purpose circuitry (e.g., logic circuitry), with or without software instructions. Embodiments can be implemented using hardwired circuitry without software instructions, or in combination with software instructions. Thus, the techniques are not limited to any specific combination of hardware circuitry and software, nor to any particular source for the instructions executed by a computing device.

While some embodiments can be implemented in fully functioning computers and computer systems, various embodiments are capable of being distributed as a computing product in a variety of forms and are capable of being applied regardless of the particular type of computer-readable medium used to actually effect the distribution.

At least some aspects disclosed can be embodied, at least in part, in software. That is, the techniques may be carried out in a computing device or other system in response to its processing device, such as a microprocessor, executing sequences of instructions contained in a memory, such as ROM, volatile RAM, non-volatile memory, cache or a remote storage device.

Routines executed to implement the embodiments may be implemented as part of an operating system, middleware, service delivery platform, SDK (Software Development Kit) component, web services, or other specific application, component, program, object, module or sequence of instructions (sometimes referred to as computer programs). Invocation interfaces to these routines can be exposed to a software development community as an API (Application Programming Interface). The computer programs typically comprise one or more instructions set at various times in various memory and storage devices in a computer, and that, when read and executed by one or more processors in a computer, cause the computer to perform operations necessary to execute elements involving the various aspects.

A computer-readable medium can be used to store software and data which when executed by a computing device causes the device to perform various methods. The executable software and data may be stored in various places including, for example, ROM, volatile RAM, non-volatile memory and/or cache. Portions of this software and/or data may be stored in any one of these storage devices. Further, the data and instructions can be obtained from centralized servers or peer to peer networks. Different portions of the data and instructions can be obtained from different centralized servers and/or peer to peer networks at different times and in different communication sessions or in a same communication session. The data and instructions can be obtained in entirety prior to the execution of the applications. Alternatively, portions of the data and instructions can be obtained dynamically, just in time, when needed for execution. Thus, it is not required that the data and instructions be on a computer-readable medium in entirety at a particular instance of time.

Examples of computer-readable media include, but are not limited to, recordable and non-recordable type media such as volatile and non-volatile memory devices, read only memory (ROM), random access memory (RAM), flash memory devices, solid-state drive storage media, removable disks, magnetic disk storage media, optical storage media (e.g., Compact Disk Read-Only Memory (CD ROMs), Digital Versatile Disks (DVDs), etc.), among others. The computer-readable media may store the instructions. Other examples of computer-readable media include, but are not limited to, non-volatile embedded devices using NOR flash or NAND flash architectures. Media used in these architectures may include un-managed NAND devices and/or managed NAND devices, including, for example, eMMC, SD, CF, UFS, and SSD.

In general, a non-transitory computer-readable medium includes any mechanism that provides (e.g., stores) information in a form accessible by a computing device (e.g., a computer, mobile device, network device, personal digital assistant, manufacturing tool having a controller, any device with a set of one or more processors, etc.). A "computer-readable medium" as used herein may include a single medium or multiple media (e.g., that store one or more sets of instructions).

In various embodiments, hardwired circuitry may be used in combination with software and firmware instructions to implement the techniques. Thus, the techniques are neither limited to any specific combination of hardware circuitry and software nor to any particular source for the instructions executed by a computing device.

Various embodiments set forth herein can be implemented using a wide variety of different types of computing devices. As used herein, examples of a "computing device" include, but are not limited to, a server, a centralized computing platform, a system of multiple computing processors and/or components, a mobile device, a user terminal, a vehicle, a personal communications device, a wearable digital device, an electronic kiosk, a general purpose computer, an electronic document reader, a tablet, a laptop computer, a smartphone, a digital camera, a residential domestic appliance, a television, or a digital music player. Additional examples of computing devices include devices that are part of what is called "the internet of things" (IOT). Such "things" may have occasional interactions with their owners or administrators, who may monitor the things or modify settings on these things. In some cases, such owners or administrators play the role of users with respect to the "thing" devices. In some examples, the primary mobile device (e.g., an Apple iPhone) of a user may be an administrator server with respect to a paired "thing" device that is worn by the user (e.g., an Apple watch).

In some embodiments, the computing device can be a computer or host system, which is implemented, for example, as a desktop computer, laptop computer, network server, mobile device, or other computing device that includes a memory and a processing device. The host system can include or be coupled to a memory sub-system so that the host system can read data from or write data to the memory sub-system. The host system can be coupled to the memory sub-system via a physical host interface. In general, the host system can access multiple memory sub-systems via a same communication connection, multiple separate communication connections, and/or a combination of communication connections.

In some embodiments, the computing device is a system including one or more processing devices. Examples of the processing device can include a microcontroller, a central processing unit (CPU), special purpose logic circuitry (e.g., a field programmable gate array (FPGA), an application specific integrated circuit (ASIC), etc.), a system on a chip (SoC), or another suitable processor.

In one example, a computing device is a controller of a memory system. The controller includes a processing device and memory containing instructions executed by the processing device to control various operations of the memory system.

Although some of the drawings illustrate a number of operations in a particular order, operations which are not order dependent may be reordered and other operations may be combined or broken out. While some reordering or other groupings are specifically mentioned, others will be apparent to those of ordinary skill in the art and so do not present an exhaustive list of alternatives. Moreover, it should be recognized that the stages could be implemented in hardware, firmware, software or any combination thereof.

Disjunctive language such as the phrase "at least one of X, Y, or Z," unless specifically stated otherwise, is otherwise understood with the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present.

In the foregoing specification, the disclosure has been described with reference to specific exemplary embodiments thereof. It will be evident that various modifications may be made thereto without departing from the broader scope as set forth in the following claims. The specification and drawings are, accordingly, to be regarded in an illustrative sense rather than a restrictive sense.

## Claims

1. An apparatus comprising:
at least one memory array (102; 206); and
at least one controller (120; 204) configured to perform wear leveling for a pool (230) of memory locations in the memory array using a plurality of gap locations (506) in a same pool (230).

2. The apparatus of claim 1, wherein the controller (120; 204) is further configured to move at least one of the gap locations (506) in response to receiving a memory management command.

3. The apparatus of claim 2, wherein an indication is provided with the memory management command indicating a number of the gap locations (506) to be moved.

4. The apparatus of any of the claims from claim 1 to 3, wherein the gap locations (506) are separated by a fixed offset.

5. The apparatus of any of the claims from claim 1 to 4, wherein the controller (120; 204) is further configured to move all of the gap locations (506) of a single pool (230) in response to a single memory management command.

6. The apparatus of any of the claims from claim 1 to 5, further comprising registers (240) configured to store respective pointers for each of the gap locations (506).

7. The apparatus of any of the claims from claim 1 to 6, further comprising a register configured to store a start location, wherein the wear leveling is performed further using the start location.

8. The apparatus of any of the claims from claim 1 to 5, further comprising a register configured to store a first gap location, wherein at least one second gap location is determined using the first gap location.

9. The apparatus of any of the claims from claim 1 to 8, wherein the gap locations (506) are cycled through a set of physical memory locations, and a start location (504) is updated when a first gap location completes a cycle through a fixed portion of the physical memory locations.

10. The apparatus of any of the claims from claim 1 to 9, wherein the controller (120; 204) is further configured to:
copy data from a first physical memory location to a second physical memory location, wherein the second physical memory location is one of the gap locations (506); and
update, based on copying the data, a pointer corresponding to moving of a first gap location.

11. A method comprising:
determining a context of a memory device (202) configured to perform memory management using multiple gaps in a single pool (230); and
modulating a time duration based on the determined context, wherein at least one of the gaps is moved within the time duration.

12. The method of claim 11, wherein a number of gaps to be moved is based on the determined context.

13. The method of any of the claims from claim 11 to 12, wherein a pointer for each moved gap is decremented.

14. The method of any of the claims from claim 11 to 13, wherein the determined context is based on a number of pending commands in a queue.

15. The method of any of the claims from claim 11 to 14, wherein the memory device (202) includes a memory array (102; 206), and the determined context is based on a characteristic of at least one memory cell (110) in the memory array.
